# FASCICULE DE BREVET EUROPEEN

(11) **EP 4 566 425 B1**
(45) Date de publication et mention de la délivrance du brevet: **03.09.2025**
(21) Numéro de dépôt: 23840965.0
(22) Date de dépôt: 22.12.2023
(51) Int. Cl.: H05K 5/06

(54) **BOÎTIER ÉLECTRONIQUE ÉTANCHE**
ABGEDICHTETES ELEKTRONISCHES GEHÄUSE
SEALED ELECTRONIC HOUSING

(30) Priorité: 24.01.2023 FR 2300628
(43) Date de publication de la demande: 11.06.2025
(73) Titulaire: Continental Automotive Technologies GmbH, 30175 Hannover (DE)
(72) Inventeur: BEKAERT, Jean-Philippe, 31100 Toulouse (FR)
(74) Mandataire: Aumovio Corporation
(86) Numéro de dépôt international: PCT/EP2023/087750
(87) Numéro de publication internationale: WO 2024/156456

(56) Documents cités:
- EP-A1- 1 633 015
- EP-A1- 3 627 980
- US-A1- 2020 221 600

## Description

### Domaine technique

La présente divulgation se relève du domaine de boîtier électronique d'antennes pour émettre et recevoir des signaux et qui peut être utilisé dans des applications mises en œuvre dans un environnement extérieur, notamment dans le domaine automobile.

### Technique antérieure

On connaît des boîtiers électroniques à circuit imprimé comportant des antennes pour recevoir et communiquer des informations à distance, qui sont par exemple présentés dans les documents EP1633015, EP3627980 et US2020/221600.

Un tel boîtier électronique comprend généralement un châssis fixé sur un capot formant ainsi une enveloppe délimitant un espace de logement. Une carte de circuit imprimé comportant la région d'antennes est reçue dans l'espace de logement. Les antennes sont tracées à proximité d'un bord de la carte de circuit imprimé. Le capot, le châssis et la carte de circuit imprimé sont ensuite fixés ensemble de manière à maintenir la carte dans le boîtier électronique par des éléments de fixation, tels que des vis.

Les enveloppes étaient principalement en matière plastique, permettant ainsi aux antennes situées à l'intérieur de l'enveloppe d'émettre et de recevoir les signaux à travers l'enveloppe. Cependant, avec l'augmentation de la puissance de calcul et la dissipation thermique requise, les enveloppes sont désormais principalement en métal qui bloquent la transmission et la réception des signaux. Une première solution consiste à agencer les antennes entièrement à l'extérieur de l'enveloppe pour éviter le phénomène de cage de Faraday. Une autre solution consiste à prévoir une ouverture dans l'enveloppe, permettant ainsi de mettre la région d'antennes en contact direct avec l'environnement extérieur de l'enveloppe pour la transmission et la réception des signaux.

Cependant ces solutions doivent continuer à assurer une bonne protection des éléments électroniques agencés dans le boîtier électronique, et notamment de garantir l'étanchéité de l'ensemble à la pénétration d'un liquide ou toute autre impureté. Par ailleurs, il est aussi souhaitable de limiter les coûts de production en limitant le nombre d'étapes d'assemblage et les coûts de stockage en limitant le nombre de pièces à assemblage.

Différentes solutions ont été proposées pour tenter de répondre à ces problématiques de manque d'étanchéité.

Dans la configuration où les antennes sont déportées par rapport à la carte électronique, c'est-à-dire la région d'antennes n'est plus portée par la carte électronique, l'ensemble comprend donc deux parties, une première partie avec la carte électronique de circuit imprimée de puissance et une deuxième partie avec la région d'antennes réalisée sur une seconde carte. Les deux parties sont généralement interconnectées par des câbles blindés. Cette solution entraîne un coût de production élevé en raison du nombre de pièces requis plus important. En outre, l'ensemble formé par les deux parties nécessite plus de place que dans le cas d'un boîtier unique, et entraîne un problème d'intégration. En outre, les pièces supplémentaires entraînent une augmentation du temps d'assemblage. Enfin, le problème d'étanchéité est reporté sur la connectique entre les deux parties. Cette solution n'est donc pas satisfaisante sur le plan d'optimisation de coût de production et sur le plan de l'étanchéité.

Afin de remédier à cet inconvénient, il a été proposé de réaliser une ouverture sur l'enveloppe au niveau de la région d'antennes pour l'émission et la réception des signaux. Ainsi, le boîtier n'est plus scindé en deux parties et comprend une unique carte sur laquelle sont tracées les antennes. Cependant, la région d'antennes étant exposée à l'environnement extérieur, il est nécessaire d'implémenter une solution d'étanchéité pour rendre l'ensemble du boîtier électronique étanche qui consiste à monter un capuchon de protection sur la carte électronique en couvrant la région d'antenne et l'ouverture. Un joint d'étanchéité est ensuite déposé au niveau des interfaces entre la bordure de l'ouverture et le capuchon pour rendre l'ensemble étanche. Cependant cette solution n'est pas entièrement satisfaisante, car elle ne permet pas un démontage de l'ensemble, entraînant une hausse du taux de rebut et complexifie la recyclabilité.

Il existe donc un besoin pour une solution d'étanchéité compatible avec toutes ces problématiques.

### Résumé

Un but de la présente divulgation est de remédier aux inconvénients de l'art antérieur.

Un but de la présente divulgation est de proposer une solution qui vise à assurer une étanchéité efficace, tout en limitant les coûts de production et garantissant une démontabilité du boîtier, dans un volume d'occupation restreint pour ne pas perturber son intégration dans les applications, notamment les applications dans le domaine automobile.

A cette fin, il est proposé un boîtier électronique d'antennes étanche comprenant :
- un châssis rigide comportant une première ouverture positionnée sur un des bords du châssis ;
- un capot rigide comportant une seconde ouverture positionnée sur un des bords du capot;
- une carte électronique comportant une région d'antennes agencée à proximité d'un bord de la carte électronique, la carte étant montée dans le boîtier de sorte qu'une face supérieure de la région d'antennes est orientée en regard de la première ouverture du châssis et une face inférieure de la région d'antennes est orientée en regard de la seconde ouverture du capot;
- un capuchon configuré pour venir s'engager sur un bord de la carte électronique afin de couvrir la région d'antennes et les première et seconde ouvertures;
- un joint d'étanchéité surmoulé sur une surface externe du capuchon en s'étendant le long des bords libres du capuchon de sorte que lorsque le capot et le châssis sont montés sur la carte électronique, le joint d'étanchéité est comprimé contre une surface du châssis et du capot pour fermer de manière étanche les deux ouvertures.

Selon un mode de réalisation, le capuchon comprend une branche supérieure et une branche inférieur reliées l'une à l'autre par une branche transversale pour former un logement en forme de U dans lequel est reçue la région d'antenne, la branche supérieure couvrant une face de la région d'antennes orientée vers le châssis et la branche inférieure couvrant une face de la région d'antennes orientée vers le capot et la branche transversale couvrant une face de la tranche de la carte électronique.

Les caractéristiques exposées dans les paragraphes suivants peuvent, optionnellement, être mises en œuvre. Elles peuvent être mises en œuvre indépendamment les unes des autres ou en combinaison les unes avec les autres :
- le joint d'étanchéité surmoulé comprend une première bande de joint d'étanchéité qui s'étend de manière continue le long du bord libre de la branche supérieure et une seconde bande de joint d'étanchéité qui s'étend de manière continue le long du bord libre de la branche inférieure et le long de l'arête entre la branche inférieure et la branche transversale.
- le capuchon comprend au moins une saille formée sur une face interne de la branche supérieure, et la carte électronique comprend au moins un trou associé destiné à recevoir ladite au moins une saillie pour le maintien du capuchon sur la carte.
- le capuchon comprend une nervure de centrage formée sur une face interne de la branche supérieure, et la carte électronique comprend une fente de centrage associée destinée à recevoir la nervure de centrage. La nervure de centrage n'est pas disposée dans le plan de symétrie du capuchon de manière à fournir un détrompage d'orientation lors de la mise en position du capuchon sur la carte électronique.
- le capuchon comprend au moins un élément de butée formé sur une face interne de la branche supérieure, un bord de la carte électronique venant en appui contre l'élément de butée lorsque le capuchon est mis en position sur la carte électronique.
- le châssis comprend une première patte de maintien positionnée dans la première ouverture et le capot comprend une seconde patte de maintien positionnée dans la seconde ouverture, les pattes de maintient s'étendant à partir d'un bord de l'ouverture perpendiculaire à la direction (F) de mise en position du capuchon parallèlement à la direction de mise en position (F) du capuchon, et le capuchon comprend une gorge associée configurée de sorte que lorsque le capot et le châssis sont montés sur la carte électronique, les première et seconde pattes de maintien sont en appui contre une portion du joint d'étanchéité surmoulée s'étendant le long de la gorge.
- le capuchon est réalisé en matériau plastique rigide et le joint d'étanchéité est en élastomère thermoplastique.

### Brève description des dessins

D'autres caractéristiques, détails et avantages apparaîtront à la lecture de la description détaillée ci-après, et à l'analyse des dessins annexés, sur lesquels :
**Fig. 1**

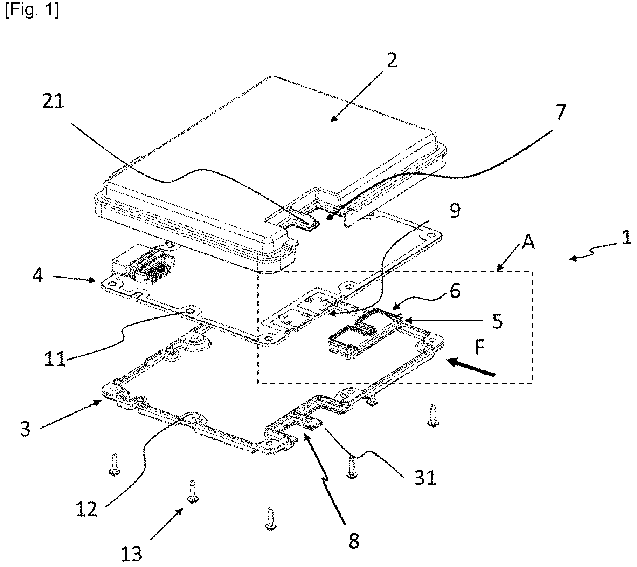

   [Fig. 1] illustre schématiquement une vue éclatée en perspective d'un boîtier électronique d'antennes étanche selon un mode de réalisation ;
**Fig. 2A**

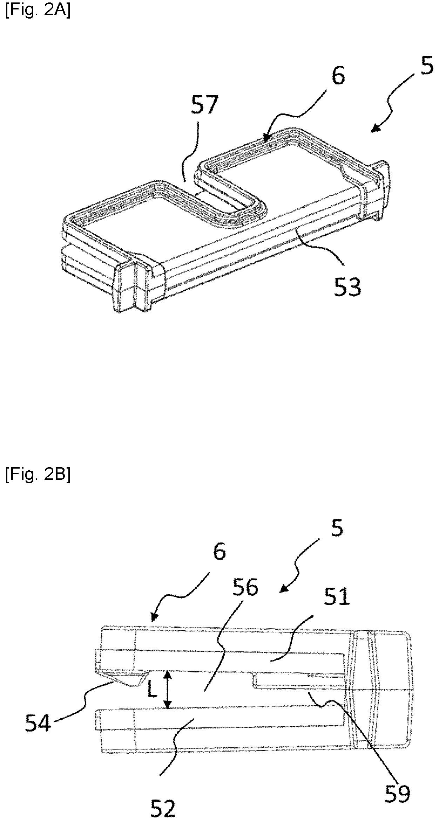

   [Fig. 2A] illustre schématiquement une vue en perspective du capuchon ;
**Fig. 2B**
   [Fig. 2B] illustre schématiquement une vue de profil du capuchon ;
**Fig. 2C**

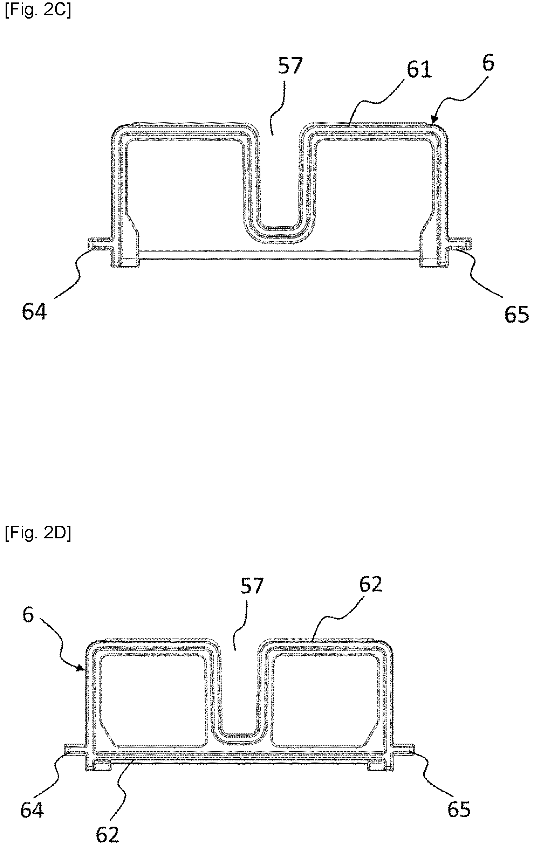

   [Fig. 2C] illustre schématiquement une vue de dessus du capuchon ;
**Fig. 2D**
   [Fig. 2D] illustre schématiquement une vue de dessous du capuchon ;
**Fig. 2E**

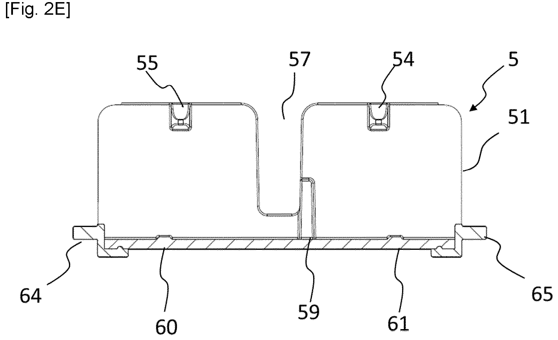

   [Fig. 2E] illustre schématiquement une vue d'une face interne du capuchon ;
**Fig. 3**

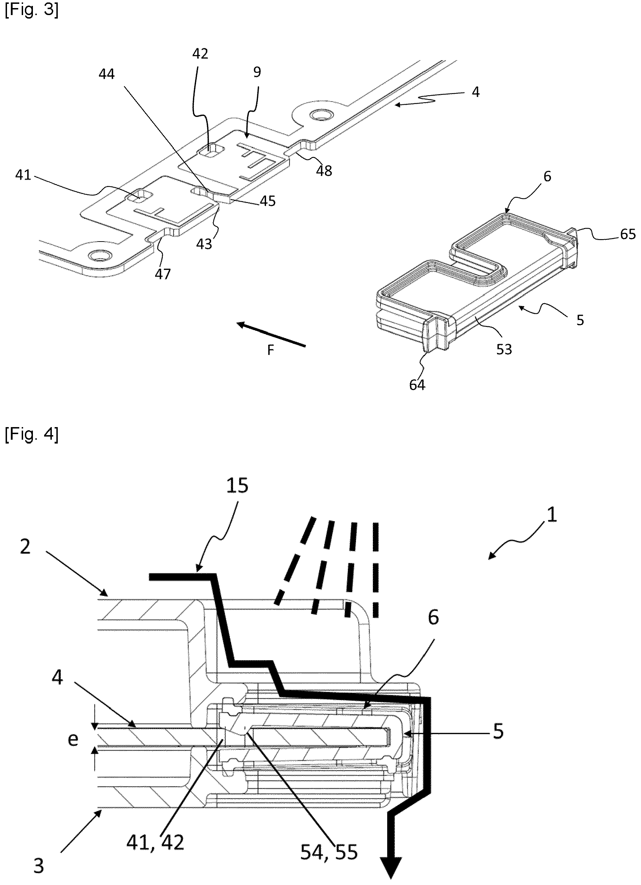

   [Fig. 3] est une vue agrandie de la zone A de la figure 1 ;
**Fig. 4**
   [Fig. 4] illustre schématiquement une vue de section du boîtier électronique d'antennes étanche de la figure 1 ;
**Fig. 5A**

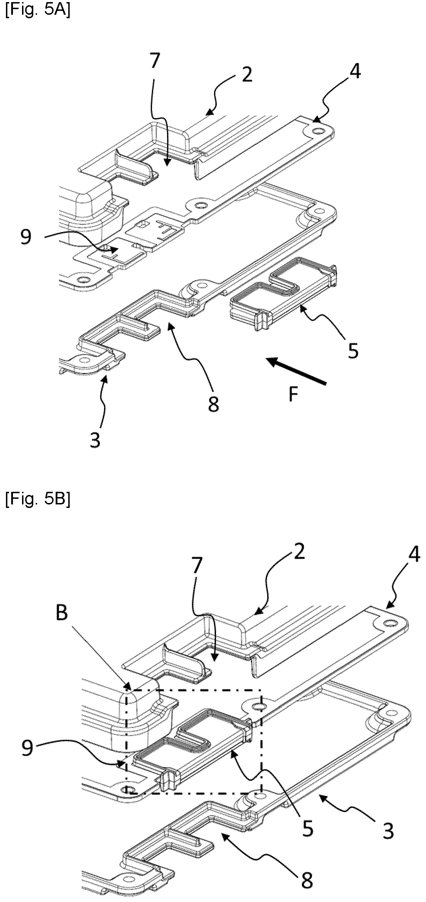

   [Fig. 5A] illustre schématiquement une étape du procédé de montage du boîtier électronique de la figure 1 dans laquelle le capuchon est dans une position pour venir s'engager sur la carte électronique ;
**Fig. 5B**
   [Fig. 5B] illustre schématiquement une étape du procédé de montage du boîtier électronique de la figure 1 dans lequel le capuchon est mis en position sur la carte électronique en couvrant la région d'antennes ;
**Fig. 5C**

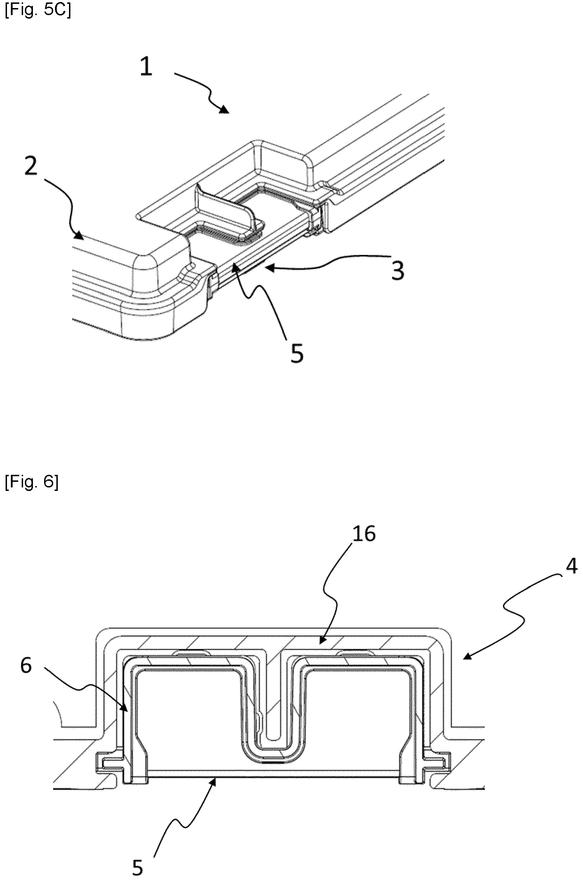

   [Fig. 5C] illustre schématiquement une étape du procédé de montage du boîtier électronique de la figure 1 dans lequel le capot et le châssis sont fixés sur la carte électronique avec le joint d'étanchéité comprimé contre le capot et le châssis pour fermer de manière étanche l'ouverture du capot et l'ouverture du châssis ;
**Fig. 6**
   [Fig. 6] illustre schématiquement une vue de dessus d'une zone agrandie (B) de la figure 5B montrant le capuchon monté sur la carte électronique.

### Description des modes de réalisation

Les dessins et la description ci-après contiennent, pour l'essentiel, des éléments de caractère certain. Ils pourront donc non seulement servir à mieux faire comprendre la présente divulgation, mais aussi contribuer à sa définition, le cas échéant.

Il est maintenant fait référence à la figure 1 qui illustre un boîtier électronique étanche 1 selon un mode de réalisation. Le boîtier électronique 1 comporte un châssis rigide 2, un capot rigide 3, une carte électronique 4 sur laquelle sont tracées des antennes 9 à proximité d'un bord de la carte électronique et un capuchon 5 muni d'un joint d'étanchéité 6.

Le boîtier électronique étanche 1 peut être par exemple un boîtier de réception radio localisé sous les ailerons d'un véhicule ou un boîtier télématique et/ou d'appel d'urgence qui doivent répondre à des critères d'étanchéité élevées pour assurer l'intégrité de la carte électronique.

Le châssis 2 et le capot 3 sont assemblés ensemble pour former un boîtier dans lequel est montée la carte électronique 4. Le capot 3 est configuré pour être fixé sur le châssis 2 et sur la carte électronique 4 de manière à maintenir la carte électronique dans le boîtier. Ainsi, le capot 3 et la carte électronique 4 comprennent une pluralité de trous de fixation 11, 12 destinés à recevoir des vis 13 permettant de fixer la carte électronique 4 et le capot 3 sur le châssis 2.

On voit à la figure 1 que la carte électronique 4 est munie d'une région d'antennes 9 pour la transmission et la réception des signaux. La région d'antennes est formée à proximité du bord de la carte électronique.

Le châssis 2 et le capot 3 sont tous deux rigides afin de garantir une bonne intégrité de la carte électronique 4. Le châssis 2 et le capot 3 sont réalisés de préférence en matériau métallique afin de garantir le blindage électro-magnétique de la carte électronique et la dissipation thermique des composants portés par la carte. Afin de permettre aux antennes d'émettre et de recevoir des signaux à traverse les parois métalliques du boîtier, le châssis 2 comporte une première ouverture 7 réalisée sur un bord du châssis et le capot 3 comporte une seconde ouverture 8 réalisée sur un bord du capot. La carte 4 est montée dans le boîtier de sorte qu'une face supérieure de la région d'antennes 9 est orientée en regard de la première ouverture 7 du châssis 2 et une face inférieure de la région d'antennes 9 est orientée en regard de la seconde ouverture 8 du capot 3. Ainsi, les signaux peuvent être émis et reçu par les antennes.

Afin d'assurer l'étanchéité du boîtier électronique, le boîtier électronique 1 comprend un capuchon 5 configuré pour venir s'engager sur un bord de la carte dans le sens de l'épaisseur de la carte électronique pour venir couvrir la région d'antennes 9, la première ouverture 7 et la seconde ouverture 8. Le capuchon 5, contrairement à l'art antérieur, est muni d'un joint d'étanchéité surmoulé 6 sur une surface externe du capuchon en s'étendant le long des bords libres du capuchon de sorte que lorsque le capot 3 et le châssis 2 sont montés sur la carte électronique 4, le joint d'étanchéité 6 est comprimé contre une surface du châssis 2 et du capot 3 pour fermer de manière étanche les deux ouvertures 7, 8, comme l'illustre la figure 4. Ainsi, il n'est plus nécessaire de déposer un joint avant ou après l'assemblage. En outre, le fait de surmouler directement le jointé d'étanchéité directement sur le capuchon permet le démontage du capuchon en cas de panne du boîtier électronique, permettant de remplacer la carte électronique défectueuse par exemple ou tout autre élément électronique. On réduit ainsi le coût de fabrication et le taux de rebut. La démontabilité du capuchon permet également de simplifier le processus de recyclage des boîtiers électroniques d'antennes.

Le capuchon 5 est réalisé dans un matériau adapté pour laisser passer les signaux. De préférence, le capuchon 5 est réalisé en matériau plastique rigide et le joint d'étanchéité 6 qui est surmoulé sur le capuchon 5 est en élastomère thermoplastique. Le joint d'étanchéité est par exemple réalisé dans un matériau thermoplastique ayant une dureté comprise entre 30 à 80 Shores A, de préférence égale à 50 Shores A.

Selon un autre avantage, le capuchon 5 est en dehors de l'enveloppe constituée par le châssis et le capot, il n'est pas soumis au risque de départ de feu. Enfin, le capuchon 5 étant réalisé dans un matériau plastique rigide, il permet une manipulation répétable, permettant l'automatisation du montage du boîtier électronique.

Les figures 2A-2E illustrent plus en détail la configure du capuchon 5 selon différentes vues.

Selon un mode de réalisation, le capuchon 5 comprend une branche supérieure 51 et une branche inférieure 52 reliées l'une à l'autre par une branche transversale 53 pour former un logement 56 en forme de U. Lorsque le capuchon est mis en position sur la carte électronique, la région d'antennes 9 est reçue dans le logement 56. En d'autres termes, la branche supérieure 51 couvre une face de la carte électronique munie de la région d'antennes orientée vers le châssis 2 et la branche inférieure 52 couvre une face de la carte électronique orientée vers le capot 3. Enfin, la branche transversale 53 couvre une face de la tranche de la carte électronique 4.

Le montage du capuchon sur la carte électronique s'effectue en l'engageant sur cette dernière dans la direction des flèches F des figures 1 et 3. La largeur du logement (L) est sensiblement supérieure à l'épaisseur de la carte électronique pour faciliter le montage.

De manière avantageuse et comme l'illustre la figure 1, le châssis 2 comprend une première patte de maintien 21 positionnée dans la première ouverture 7 et le capot 3 comprend une seconde patte de maintien 31 positionnée dans la seconde ouverture 8. Les deux pattes de maintien 21, 31 s'étendent à partir d'un bord de l'ouverture qui est perpendiculaire à la direction (F) de mise en position du capuchon parallèlement à la direction de mise en position (F) du capuchon. Ainsi, lorsque le capot 3 et le châssis 2 sont montés sur la carte électronique 4, la première patte de maintien 21 est en appui contre une face de la branche supérieure 51 du capuchon 5 et la seconde patte de maintien 31 en appui contre une face de la branche inférieure 52 du capuchon 5. Ainsi, la présence de ces deux pattes permet d'améliorer le maintien en position du capuchon sur la carte électronique et de limiter le stress de cette carte lors de la manipulation. Dans le cas de capot et châssis métallique, les pattes 21 et 31 permettent une séparation électromagnétique des antennes.

On voit sur la figure 1 que les première et seconde pattes de maintien 21, 31 sont positionnées sensiblement au centre des première et seconde ouvertures. Le capuchon 5 comprend également une gorge supérieure 57 dans la branche supérieure 51 et une gorge inférieure 57 dans la branche inférieure 52. Les deux gorges présentent une forme en U qui s'étendent parallèlement à la direction de mise en position (F) du capuchon. Elles sont positionnées sensiblement au centre des deux branches et positionnées en regard. Ainsi, lorsque le capuchon 5 est mis en position sur la carte électronique 4, et lorsque le capot 3 et le châssis 2 sont montés sur la carte électronique 4, les première et seconde pattes de maintien 21, 31 sont en appui contre les bords libres des deux gorges, en venant couvrir les deux gorges comme l'illustre la figure 5C.

On voit sur la figure 2C que le joint d'étanchéité surmoulé 6 comprend une première bande de joint d'étanchéité 61 qui s'étend de manière continue le long du bord libre de la branche supérieure.

On voit sur la figure 2D que le joint d'étanchéité surmoulé 6 comprend une seconde bande de joint d'étanchéité 62 qui s'étend de manière continue le long du bord libre de la branche inférieure. De manière avantageuse, la seconde bande de joint d'étanchéité 62 s'étend de manière continue le long du bord libre de la branche inférieure et le long de l'arête entre la branche inférieure 52 et la branche transversale 53.

Ainsi, lorsque le capot et le châssis sont montés sur la carte électronique, la première bande de joint d'étanchéité 61 est comprimée contre le bord de la première ouverture 7 et la première patte de maintien 21, la seconde bande de joint d'étanchéité 62 est comprimée contre le bord de la seconde ouverture 8 et la seconde patte de maintien 31. La présence de ces bandes d'étanchéité permet de rendre le boîtier électronique étanche.

On notera que le fait de disposer d'un joint d'étanchéité le long de l'arête entre la branche inférieure 52 et la branche transversale 53 permet d'empêcher le liquide de pénétrer dans l'interstice entre la branche transversale et la face interne du capot. Sur la figure 4, on voit que lorsque le capot et le châssis sont montés sur la carte électronique, la bande de joint d'étanchéité 61 de la branche supérieure est comprimée contre le châssis et la première patte d'extension, la seconde bande de joint d'étanchéité 62 de la branche inférieure est comprimée contre le capot et la seconde patte d'extension. Les bandes de joint d'étanchéité forment ainsi une barrière de protection pour empêcher la pénétration de liquide dans les ouvertures pratiquées sur le capot et le châssis. Sur la figure 4, on voit que les gouttes d'eau qui arrivent sur le boîtier suivent naturellement un chemin d'écoulement représenté par une flèche le long des faces externes du capuchon et sont empêchées de pénétrer à l'intérieur du logement en forme de U où se trouve la région d'antennes.

Avantageusement et comme l'illustre la figure 3, chaque bande de joint d'étanchéité comprend deux extensions 64, 65 qui s'étendent dans le prolongement de la brache transversale 53, de part et d'autre de la branche transversale. La carte électronique comprend deux creux 47, 48 correspondants dans lesquels viennent se loger les extensions 64, 65 lorsque le capuchon vient s'engager sur la carte électronique. La présence de ces deux extensions contribue à l'étanchéité du boîtier électronique.

De manière avantageuse, le matériau thermoplastique sélectionné pour réaliser le joint d'étanchéité surmoulé est choisi de préférence dans une couleur qui permet de contraster avec celle du matériau rigide choisi pour réaliser le capuchon. Cette solution permet de faciliter la vérification de l'intégrité du montage par une inspection visuelle.

De manière avantageuse, le matériau thermoplastique est sélectionné selon les critères additionnels suivants :
- ayant une adhésion chimique compatible avec le matériau du capuchon ;
- ayant une propriété diélectrique et d'absorption des ondes compatibles avec la gamme de fréquences de fonctionnement des antennes du boîtier électronique, typiquement celle des fonctions Bluetooth, wifi, GPS mais aussi des bandes AM et FM ;
- ayant une bonne tenue en température, typiquement de -40 à 105°C.

Selon un mode de réalisation particulièrement avantageuse, le capuchon est muni d'éléments qui permettent de faciliter le montage le capuchon sur la carte électronique et d'améliorer le maintien du capuchon sur la carte électronique.

Dans l'exemple illustré sur la figure 2E et la figure 3, le capuchon 5 comprend deux saillies de clipsage 54, 55 formées sur une face interne de la branche supérieure 5 et la carte 4 comprend deux trous 41, 42 associés formés à proximité de la région d'antennes 9. Chaque saillie est destinée à venir s'insérer dans un trou correspondant lorsque le capuchon 5 est mis en position sur la carte électronique 4. Cette combinaison entre la saille et le trou permet de maintenir le capuchon sur la carte électronique pendant le montage. On notera que l'utilisation des saillies de clipsage permet de démonter facilement le capuchon par rapport à l'utilisation des moyens de fixation par vissage.

Selon l'exemple de réalisation illustré sur la figure 2E, les saillies de clipsage 55, 54 sont formées à proximité du bord libre de la face interne de la branche supérieure, sur le côté opposé à la branche transversale.

De manière avantageuse, on notera que la saillie présente une forme de cône tronqué (visible sur la figure 2B) dont les arêtes forment des surfaces de rampe inclinées. Ainsi, lors de l'engagement du capuchon sur la carte électronique, les saillies peuvent s'insérer facilement dans les trous associés sans exercer de pression sur la carte électronique.

De manière avantageuse, le capuchon 5 comprend en outre une nervure de centrage 59 formée sur une face interne de la branche supérieure 5 et la carte 4 comprend une fente de centrage 43 associée formée sur le bord de la région d'antenne 9. La fente de centrage 43 est destinée à recevoir la nervure de centrage 59 lorsque le capuchon vient s'engager sur la carte électronique, permettant ainsi d'aider au centrage de la carte par rapport à la région d'antenne.

Selon l'exemple de réalisation illustré sur la figure 2E, la nervure de centrage 59 et la fente 43 présentent une forme allongée orientée dans la direction (F) de mise en position du capuchon sur la carte électronique.

De manière avantageuse, la nervure de centrage 59 n'est pas disposée dans le plan de symétrie du capuchon 5 de manière à fournir un détrompage d'orientation lors de la mise en position du capuchon sur la carte électronique.

Comme l'illustre la figure 3, on notera que la fente 43 présente une ouverture légèrement restreinte 44 pour gérer localement le jeu avec la nervure de centrage 59, et elle est évasée vers l'extérieur à son extrémité, comme indiqué en 45, pour permettre une insertion facile de la nervure de centrage 59 dans la fente 43.

Comme l'illustre la figure 2E, le capuchon 5 comprend en outre deux éléments de butée 60 formés sur une face interne de la branche supérieure. Ces éléments de buté servent de surface d'appui lorsque le capuchon est monté sur la carte électronique. Ainsi, lorsque le capuchon est mis en position sur la carte, un bord de la carte électronique est en appui contre les éléments de butée. Les éléments de butée ont pour fonction de marquer l'arrêt de l'engagement du capuchon sur la carte électronique afin d'éviter un risque de pression appliquée sur la carte pendant le montage.

En référence aux figures 5A-5C, le procédé de montage du boîtier électronique 1 est décrit ci-dessous et comprend les étapes suivantes.

On fournit le châssis 2, le capot 3, la carte électronique 4 munie de la région d'antennes 9 et le capuchon 5 avec le joint d'étanchéité surmoulé 6 directement sur les surfaces externes du capuchon.

Le capuchon 5 est centré par rapport à la région d'antennes 9 grâce à la combinaison de la nervure de centrage 59 et de la fente de centrage 43. Le capuchon 5 est ensuite engagé sur la carte électronique 4 dans la direction de la flèche F. Dans ce mouvement, les braches du capuchon 5 sont légèrement écartées par le bord de la carte électronique du fait de la forme légèrement arrondie des extrémités des branches et les saillies 54, 55 sont ensuite insérées dans les trous associés 41, 42 présents sur la carte électronique 4 pour le maintien du capuchon 5 sur la carte électronique 4.

La région d'antennes 9 est ainsi protégée par la branche supérieure et la branche inférieure du capuchon comme l'illustre la figure 5B.

On place le châssis 2 contre une face de la carte électronique 4 et le capot 3 contre une face opposée de la carte électronique de sorte que la région d'antennes 9 soit en regard de l'ouverture 7 du châssis et la face opposée de la région d'antennes soit en regard de l'ouverture 8 du capot.

On fixe le capot 3 sur la carte électronique 4 par des vis de fixation 13.

On fixe le capot 3 sur le châssis 2 par des vis de fixation 13.

Les différentes étapes peuvent être réalisées dans l'ordre décrit ici ou, pour certaines dans un ordre différent. De même, les étapes peuvent être réalisées de manière séquentielle ou, pour certaines, de manière simultanée.

Selon un autre exemple de réalisation, les étapes de fixation du capot sur la carte électronique et de fixation du capot sur le châssis peuvent être réalisées de manière simultanée.

On notera que, puisque le joint d'étanchéité 6 est directement surmoulé sur le capuchon, on réduit le nombre d'étapes en supprimant l'étape de dépôt du joint d'étanchéité et donc les coûts liés à la production et au montage du boîtier électronique.

La solution de la présente divulgation permet de répondre à des problèmes d'étanchéités des boîtiers électroniques dont le châssis et le capot sont en matériau métallique et qui comportent des antennes.

Le boîtier électronique de la présente invention présente les avantages techniques suivants :
- Le boîtier électronique est démontable grâce à la présence du joint d'étanchéité surmoulé sur le capuchon, permettant ainsi de réparer le boîtier et de recycler les éléments du boîtier.
- les antennes restent sur la carte électronique principale, il n'est pas nécessaire de déporter les antennes en dehors de la carte électronique principale. La solution de la présente invention permet ainsi de réduire les coûts de production.
- il n'est plus nécessaire de mettre en œuvre des procédés de dépôt de joint d'étanchéité, permettant ainsi de réduire le coût de machine et le temps de production.
- grâce à l'architecture du capuchon, il est possible d'implémenter une cloison de blindage 16 au châssis et au capot en entourant la région d'antenne comme l'illustre la figure 6, permettant ainsi de séparer les antennes du reste de la carte électronique. Les antennes ne sont donc plus perturbées par les autres sources de électromagnétiques de la carte électronique.

### Application industrielle

Le boîtier électronique selon l'invention est particulièrement adapté pour équiper les dispositifs connectés d'un véhicule automobile. Il peut également équiper tous les produits connectés qui sont munis d'antennes internes logées dans un boîtier dont l'enveloppe est métallique.

## Revendications

1. Boîtier électronique d'antennes étanche (1) comprenant :
- un châssis rigide (2) comportant une première ouverture (7) positionnée sur un des bords du châssis ;
- un capot rigide (3) comportant une seconde ouverture (8) positionnée sur un des bords du capot;
- une carte électronique (4) comportant une région d'antennes (9) agencée à proximité d'un bord de la carte électronique, la carte étant montée dans le boîtier de sorte qu'une face supérieure de la région d'antennes soit orientée en regard de la première ouverture (7) du châssis et une face inférieure de la région d'antennes (9) soit orientée en regard de la seconde ouverture (8) du capot;
- un capuchon (5) configuré pour venir s'engager sur un bord de la carte électronique (4) afin de couvrir la région d'antennes et les première et seconde ouvertures;
- un joint d'étanchéité (6) surmoulé sur une surface externe du capuchon en s'étendant le long des bords libres du capuchon (5) de sorte que lorsque le capot (3) et le châssis (2) sont montés sur la carte électronique (4), le joint d'étanchéité (6) est comprimé contre une surface du châssis et du capot pour fermer de manière étanche les deux ouvertures.

2. Boîtier selon la revendication 1, dans lequel le capuchon (5) comprend une branche supérieure (51) et une branche inférieur (52) reliées l'une à l'autre par une branche transversale (53) pour former un logement (56) en forme de U dans lequel est reçue la région d'antennes (9), la branche supérieure couvrant une face de la région d'antennes orientée vers le châssis (2) et la branche inférieure couvrant une face de la région d'antennes orientée vers le capot (3) et la branche transversale couvrant une face de la tranche de la carte électronique (4).

3. Boîtier selon la revendication 2, dans lequel le joint d'étanchéité surmoulé (6) comprend une première bande de joint d'étanchéité (61) qui s'étend de manière continue le long du bord libre de la branche supérieure et une seconde bande de joint d'étanchéité (62) qui s'étend de manière continue le long du bord libre de la branche inférieure et le long de l'arête entre la branche inférieure (52) et la branche transversale (53).

4. Boîtier selon l'une des revendications 2 à 3, dans lequel le capuchon (5) comprend au moins une saille (54, 55) formée sur une face interne de la branche supérieure, et la carte électronique (4) comprend au moins un trou (41, 42) associé destiné à recevoir ladite au moins une saillie pour le maintien du capuchon sur la carte.

5. Boîtier selon l'une des revendications 2 à 4, dans lequel le capuchon (5) comprend une nervure de centrage (59) formée sur une face interne de la branche supérieure, et la carte électronique (4) comprend une fente de centrage (43) associée destinée à recevoir la nervure de centrage.

6. Boîtier selon la revendication 5, dans lequel la nervure de centrage (59) n'est pas disposée dans le plan de symétrie du capuchon (5) de manière à fournir un détrompage d'orientation lors de la mise en position du capuchon sur la carte électronique.

7. Boîtier selon l'une des revendications 2 à 6, dans lequel le capuchon (5) comprend au moins un élément de butée (60, 61) formé sur une face interne de la branche supérieure, un bord de la carte électronique venant en appui contre l'élément de butée lorsque le capuchon est mis en position sur la carte électronique.

8. Boîtier selon l'une des revendications précédentes, dans lequel le châssis (2) comprend une première patte de maintien (21) positionnée dans la première ouverture (7) et le capot (3) comprend une seconde patte de maintien (31) positionnée dans la seconde ouverture (8), les pattes de maintient s'étendant à partir d'un bord de l'ouverture perpendiculaire à la direction (F) de mise en position du capuchon parallèlement à la direction de mise en position (F) du capuchon, et le capuchon comprend une gorge (57) associée configurée de sorte que lorsque le capot (3) et le châssis (2) sont montés sur la carte électronique (4), les première et seconde pattes de maintien sont en appui contre une portion du joint d'étanchéité surmoulée s'étendant le long de la gorge (57).

9. Boîtier selon l'une des revendications précédentes, dans lequel le capuchon (5) est réalisé en matériau plastique rigide et le joint d'étanchéité (6) est en élastomère thermoplastique.

## Patentansprüche

1. Dichtes Elektronikgehäuse mit Antennen (1), welches umfasst:
- einen starren Rahmen (2), der eine erste Öffnung (7) aufweist, die an einem der Ränder des Rahmens positioniert ist;
- eine starre Abdeckung (3), die eine zweite Öffnung (8) aufweist, die an einem der Ränder der Abdeckung positioniert ist;
- eine Elektronikplatine (4), die einen Antennenbereich (9) aufweist, der in der Nähe eines Randes der Elektronikplatine angeordnet ist, wobei die Platine so in dem Gehäuse angebracht ist, dass eine Oberseite des Antennenbereichs der ersten Öffnung (7) des Rahmens gegenüberliegend ausgerichtet ist und eine Unterseite des Antennenbereichs (9) der zweiten Öffnung (8) der Abdeckung gegenüberliegend ausgerichtet ist;
- eine Kappe (5), die dafür ausgelegt ist, an einem Rand der Elektronikplatine (4) anzugreifen, um den Antennenbereich und die erste und die zweite Öffnung zu bedecken;
- eine Dichtung (6), die auf eine Außenfläche der Kappe aufgeformt ist, wobei sie sich entlang der freien Ränder der Kappe (5) erstreckt, so dass, wenn die Abdeckung (3) und der Rahmen (2) auf der Elektronikplatine (4) angebracht sind, die Dichtung (6) gegen eine Fläche des Rahmens und der Abdeckung gedrückt wird, um die zwei Öffnungen auf dichte Weise zu verschließen.

2. Gehäuse nach Anspruch 1, wobei die Kappe (5) einen oberen Schenkel (51) und einen unteren Schenkel (52) umfasst, die durch einen Querschenkel (53) miteinander verbunden sind, um eine U-förmige Aufnahme (56) zu bilden, in welcher der Antennenbereich (9) aufgenommen ist, wobei der obere Schenkel eine Seite des Antennenbereichs bedeckt, die dem Rahmen (2) zugewandt ist, und der untere Schenkel eine Seite des Antennenbereichs bedeckt, die der Abdeckung (3) zugewandt ist, und der Querschenkel eine Schmalseite der Elektronikplatine (4) bedeckt.

3. Gehäuse nach Anspruch 2, wobei die aufgeformte Dichtung (6) einen ersten Dichtungsstreifen (61), der sich durchgehend entlang des freien Randes des oberen Schenkels erstreckt, und einen zweiten Dichtungsstreifen (62), der sich durchgehend entlang des freien Randes des unteren Schenkels und entlang der Kante zwischen dem unteren Schenkel (52) und dem Querschenkel (53) erstreckt, umfasst.

4. Gehäuse nach einem der Ansprüche 2 bis 3, wobei die Kappe (5) mindestens einen Vorsprung (54, 55) umfasst, der auf einer Innenseite des oberen Schenkels ausgebildet ist, und die Elektronikplatine (4) mindestens ein zugeordnetes Loch (41, 42) umfasst, das dazu bestimmt ist, den mindestens einen Vorsprung zum Halten der Kappe auf der Platine aufzunehmen.

5. Gehäuse nach einem der Ansprüche 2 bis 4, wobei die Kappe (5) eine Zentrierrippe (59) umfasst, die auf einer Innenseite des oberen Schenkels ausgebildet ist, und die Elektronikplatine (4) einen zugeordneten Zentrierschlitz (43) umfasst, der dazu bestimmt ist, die Zentrierrippe aufzunehmen.

6. Gehäuse nach Anspruch 5, wobei die Zentrierrippe (59) nicht in der Symmetrieebene der Kappe (5) angeordnet ist, um so einen Verwechslungsschutz für die Ausrichtung bei der Positionierung der Kappe auf der Elektronikplatine bereitzustellen.

7. Gehäuse nach einem der Ansprüche 2 bis 6, wobei die Kappe (5) mindestens ein Anschlagelement (60, 61) umfasst, das auf einer Innenseite des oberen Schenkels ausgebildet ist, wobei ein Rand der Elektronikplatine an dem Anschlagelement zur Anlage kommt, wenn die Kappe in ihre Position auf der Elektronikplatine gebracht wird.

8. Gehäuse nach einem der vorhergehenden Ansprüche, wobei der Rahmen (2) eine erste Haltelasche (21) umfasst, die in der ersten Öffnung (7) positioniert ist, und die Abdeckung (3) eine zweite Haltelasche (31) umfasst, die in der zweiten Öffnung (8) positioniert ist, wobei sich die Haltelaschen von einem zur Positionierungsrichtung (F) der Kappe senkrechten Rand der Öffnung aus parallel zur Positionierungsrichtung (F) der Kappe erstrecken und die Kappe eine zugeordnete Auskehlung (57) umfasst, die so ausgebildet ist, dass, wenn die Abdeckung (3) und der Rahmen (2) auf der Elektronikplatine (4) angebracht sind, die erste und die zweite Haltelasche an einem Abschnitt der aufgeformten Dichtung anliegen, der sich entlang der Auskehlung (57) erstreckt.

9. Gehäuse nach einem der vorhergehenden Ansprüche, wobei die Kappe (5) aus starrem Kunststoff hergestellt ist und die Dichtung (6) aus thermoplastischem Elastomer besteht.

## Claims

1. Sealed electronic antenna box (1) comprising:
- a rigid chassis (2) having a first opening (7) positioned at one of the edges of the chassis;
- a rigid cover (3) having a second opening (8) positioned at one of the edges of the cover;
- an electronic board (4) having an antenna region (9) arranged close to one edge of the electronic board, the board being mounted in the box such that an upper face of the antenna region is oriented so as to face the first opening (7) in the chassis and a lower face of the antenna region (9) is oriented so as to face the second opening (8) in the cover;
- a cap (5) configured to engage with an edge of the electronic board (4) so as to cover the antenna region and the first and second openings;
- a seal (6) overmolded on an external surface of the cap, extending along the free edges of the cap (5) such that when the cover (3) and the chassis (2) are mounted on the electronic board (4), the seal (6) is compressed against a surface of the chassis and of the cover in order to close the two openings in a sealed manner.

2. Box according to Claim 1, wherein the cap (5) comprises an upper arm (51) and a lower arm (52) that are connected together by a transverse arm (53) so as to form a U-shaped housing (56) in which the antenna region (9) is received, the upper arm covering a face of the antenna region that is oriented toward the chassis (2) and the lower arm covering a face of the antenna region that is oriented toward the cover (3), and the transverse arm covering an edge face of the electronic board (4).

3. Box according to Claim 2, wherein the overmolded seal (6) comprises a first seal strip (61) which extends continuously along the free edge of the upper arm, and a second seal strip (62) which extends continuously along the free edge of the lower arm and along the ridge between the lower arm (52) and the transverse arm (53).

4. Box according to either of Claims 2 and 3, wherein the cap (5) comprises at least one protrusion (54, 55) formed on an internal face of the upper arm, and the electronic board (4) comprises at least one associated hole (41, 42) which is intended to receive said at least one protrusion in order to retain the cap on the board.

5. Box according to any of Claims 2 to 4, wherein the cap (5) comprises a centering rib (59) formed on an internal face of the upper arm, and the electronic board (4) comprises an associated centering slot (43) which is intended to receive the centering rib.

6. Box according to Claim 5, wherein the centering rib (59) is not disposed in the plane of symmetry of the cap (5) so as to provide an orienting poka-yoke while the cap is being positioned on the electronic board.

7. Box according to one of Claims 2 to 6, wherein the cap (5) comprises at least one stop element (60, 61) formed on an internal face of the upper arm, an edge of the electronic board bearing against the stop element when the cap is positioned on the electronic board.

8. Box according to one of the preceding claims, wherein the chassis (2) comprises a first retaining tab (21) positioned in the first opening (7) and the cover (3) comprises a second retaining tab (31) positioned in the second opening (8), the retaining tabs extending parallel to the positioning direction (F) of the cap from an edge of the opening that is perpendicular to the positioning direction (F) of the cap, and the cap comprises an associated groove (57) which is configured such that when the cover (3) and the chassis (2) are mounted on the electronic board (4), the first and second retaining tabs bear against a portion of the overmolded seal extending along the groove (57).

9. Box according to one of the preceding claims, wherein the cap (5) is made of rigid plastics material and the seal (6) is made of thermoplastic elastomer.
